# EUROPÄISCHE PATENTANMELDUNG

(11) **EP 1 217 387 A2**
(43) Veröffentlichungstag der Anmeldung: **26.06.2002**
(21) Anmeldenummer: 01000770.6
(22) Anmeldetag: 19.12.2001
(51) Int. Cl.: G01T 1/00

(54) **Szintillationsdetektor für elektromagnetische Strahlung**

(30) Priorität: 21.12.2000 DE 10063907
(71) Anmelder: Philips Corporate Intellectual Property GmbH, 52066 Aachen (DE); Koninklijke Philips Electronics N.V., 5621 BA Eindhoven (NL)
(72) Erfinder: Dorscheid, Ralf, Weisshausstrasse 2, 52066 Aachen (DE); Grätz, Petra, Weisshausstrasse 2, 52066 Aachen (DE)
(74) Vertreter: Volmer, Georg, Dipl.-Ing.

(57) **Zusammenfassung**

Die Erfindung betrifft einen Detektor zum Detektieren von elektromagnetischer Strahlung mit zumindest einem Szintillator (6), zumindest einem CMOS - Chip (3) und einem keramischen Basiselement (4), wobei jeweils zwischen dem Szintillator (6) und dem CMOS - Chip (3) bzw. zwischen dem CMOS - Chip (3) und dem keramischen Basiselement (4) eine blasenfreie und bezüglich ihrer Spaltbreite definierte Zwischenschicht (2) angeordnet ist und diese Zwischenschicht (2) zumindest zwei Klebstoffe (A, B) mit unterschiedlicher Konsistenz und Abstandhalter (5) enthält.

## Beschreibung

Die Erfindung betrifft einen Detektor zum Detektieren von elektromagnetischer Strahlung mit zumindest einem Szintillator, zumindest einem CMOS-Chips und einem keramischen Basiselement, wobei jeweils zwischen dem Szintillator und dem CMOS-Chip bzw. zwischen dem CMOS-Chip und dem keramischen Basiselement eine Zwischenschicht angeordnet ist. Ein weiterer Aspekt der Erfindung betrifft die Herstellung einer solchen blasenfreien Zwischenschicht bzw. die Herstellung eines Detektors mit einer solchen Zwischenschicht.

Derartige Detektoren werden zur Umwandlung von beispielsweise Röntgenstrahlung in Strahlung im sichtbaren Lichtbereich, beispielsweise in Röntgenuntersuchungsgeräten, eingesetzt.

Detektoren beispielsweise für Röntgenuntersuchungsgeräte sind üblicherweise in Kombination mit Szintillatoren, CMOS-Chips und einem keramischen Basiselement aufgebaut, wobei die auf dem CMOS-Chip angebrachte Fotosensoreinrichtung das vom Szintillator emittierte Licht detektiert.

Die Gleichmäßigkeit der Spaltbreite der vorgenannten Zwischenschicht zwischen Szintillator und CMOS-Chip beeinflusst wesentlich die Detektionsgenauigkeit des Detektors und somit die Bildqualität des Röntgenuntersuchungsgerätes insgesamt. Lufteinschlüsse in der Zwischenschicht beeinflussen die Detektionsgenauigkeit des Detektors negativ.

In der JP 09054162 A wird ein Röntgendetektor beschrieben, bei dem zwischen dem Szintillator-Bereich und dem Bereich der Fotosensoren eine transparente Zwischenschicht, bestehend aus ausgshärtetem Klebstoff, angeordnet ist.

Die Spaltbreite der Zwischenschicht wird durch einen Abstandhalter bestimmt, wobei insbesondere ein Klebeband zur Verbesserung der Gleichmäßigkeit der Spaltbreite verwendet wird. In einem bevorzugtem Ausführungsbeispiel ist bei einer senkrechten Anordnung des Szintillator - Bereiches und des Bereiches der Fotosensoren der Klebstoffeintrag von oben durch Kapillarwirkung und Schwerkraft beschrieben, wobei sich am unteren Spaltende ein Abstandhalter befindet. Diese senkrechte Anordnung ist im Rahmen einer industriellen Fertigung technologisch sehr aufwendig, da diesbezügliche Fertigungprozesse regelmäßig kostengünstig auf horizontaler Ebene erfolgen. Bei der vorgenannten Anordnung eines Klebebandes am unteren Ende des Spaltes wird die für das vollständige Einbringen erforderliche Kapillarwirkung teilweise beschränkt, die angestrebte vollständige Verdrängung der Luft ist somit nicht möglich. Regelmäßig sind Kapillarkräfte nur in offenen Systemen anzutreffen, was bei der gegebenen Anordnung am unteren Spaltende nur bedingt geben ist. Ein weiteres Problem ist das Handling des beschriebenen Abstandhalters, insbesondere das Anbringen eines Klebebandes, bei den hier relevanten Größenverhältnissen im µm - Bereich.

Aufgabe der Erfindung ist es, einen Detektor anzugeben, der eine oder mehrere Zwischenschichten besitzt, die einen hohen Grad bezüglich der Gleichmäßigkeit der Spaltbreite realisieren, und der sich in hohen Stückzahlen zu vertretbaren Kosten herstellen lässt. Außerdem ist es Aufgabe der Erfindung, Verfahren zur Herstellung der vorgenannten Zwischenschichten und zur Herstellung von Detektoren unter Verwendung der vorgenannten Verfahren bereitzustellen, die sich bei vertretbaren Kosten industriell herstellen lassen.

Die Aufgabe wird dadurch gelöst, dass der Detektor zum Detektieren von elektromagnetischer Strahlung mit zumindest einem Szintillator, zumindest einem CMOS - Chip und einem keramischen Basiselement besteht, wobei jeweils zwischen dem Szintillator und dem CMOS - Chip bzw. zwischen dem CMOS - Chip und dem keramischen Basiselement eine und bezüglich ihrer Spaltbreite definierte Zwischenschicht angeordnet ist und diese Zwischenschicht zumindest zwei Klebstoffe (A, B) mit unterschiedlicher Konsistenz enthält.

Der Detektor, der insbesondere als Röntgendetektor oder als Detektor für Computertomographiegeräte (CT - Geräte) eingesetzt wird, weist eine Zwischenschicht auf, die insbesondere als Klebstoff realisiert ist. Durch die Verwendung von Klebstoff für die Zwischenschichten lassen sich zuverlässige mechanisch und thermisch stabile Verbindungen gewährleisten.

Die gewünschte definierte Spaltbreite der Zwischenschicht wird insbesondere durch die diesbezügliche Auswahl der Abstandhalter erreicht. Abstandhalter im Sinne der Erfindung sind alle Bauteile, die allein der gewünschten Beabstandung dienen, wie Drähte, oder Bauteile, die anderweitig funktional erforderlich sind, d.h. deren Dimension, ggf. diesbezüglich speziell ausgewählt, ausgenutzt wird, wie z. B. auf dem CMOS - Chip befindliche Bumps. Die jeweils gewünschte Spaltbreite ist durch entsprechende Auswahl der Größe des Abstandhalters in einfacher Art und Weise erreichbar. Zweckmäßigerweise wird ein handelsüblicher Draht mit kreisrundem Querschnitt verwendet. Solche Drähte sind regelmäßig in Standardmaßen von 15 bis 75 µm, für die hier bevorzugten Werkstoffe, wie Au und AlSil, kostengünstig erhältlich. Andererseits kann bei der Ausbildung der Bumps mit herkömmlichen Verfahren gezielt auf die Einhaltung der gewünschten Höhe der Bumps Einfluss genommen werden, so dass die gewünschte Maßgenauigkeit technologisch einfach realisierbar ist. Die Abstandhalter bzw. die Klebepunkte für den Klebstoff (A) werden vorzugsweise in solchen Bereichen angeordnet, die die Funktion des Detektors nicht wesentlich beeinflussen, wie beispielsweise in optisch nicht aktiven Gebieten auf dem CMOS - Chip. Keine zusätzliche Fläche wird durch die vorgenannte Plazierung und den Einsatz von kleinsten Teilmengen des Klebstoffes (A) notwendig wobei dennoch der Hauptzweck des Einsatzes des Klebstoffes (A) erreicht wird. Dieser dient ursächlich der schnellen Fixierung der gewünschten gleichmäßigen Spaltbreite, bei minimalen diesbezüglichen Materialeinsatz.

Abgestimmt auf diesen Verwendungszweck kommen erfindungsgemäß handelsübliche Epoxidharz -, Cyanacrylat- oder Acrylatklebstoffe als Klebstoff (A) zum Einsatz, die leicht verarbeitbar sind und schnell aushärten.

Klebstoff (A1) ist elektrisch leitfähig, um Aufladungen rückseitig vom CMOS-Chip ableiten zu können.

Bevorzugt wird in Bezug auf eine möglichst geringe Spaltbreite, dass zumindest einige Teilmengen des Klebstoffes (A1), insbesondere an den Klebepunkten, sowohl direkt mit den rückseitigen Oberflächen des CMOS - Chips als auch mit dem keramischen Basiselement verbunden sind. In diesem Fall sind zwischen den Oberflächen des CMOS - Chip und dem keramischen Basiselement mehrere Abstandhalter unmittelbar, d.h. insbesondere ohne dass Teilmengen des Klebstoffes (A1) mit diesen in Kontakt kommen, angeordnet.

Weiterhin bevorzugt wird, dass zumindest einige Teilmengen des Klebstoffes (A2) sowohl mit der Oberfläche des Szintillators als auch mit den auf dem CMOS - Chip befindlichen Bumps verbunden sind.

Der Klebstoff (B) ist erfindungsgemäß ein niederviskoser 2-Komponenten-Klebstoff, vorzugsweise auf Epoxidharzbasis, der einen Brechungsindex > 1,5 besitzt und Licht in den Wellenlängen zwischen 450 bis 550 nm verlustarm überträgt. Dieser Klebstoff (B), der den größten Anteil an der Gesamtklebekraft in der Zwischenschicht realisiert, altert auch über längere Zeiträume durch elektromagnetische Bestrahlung nicht signifikant. Ein gutes Fließverhalten ist insbesondere erforderlich, um ein vollständiges und blasenfreies Unterfüllen sicher zu gewährleisten. Das Aushärten des Klebstoffes (B) kann zweckmäßigerweise an die Temperaturbelastbarkeit der Kontaktpartner angepasst werden.

Die Aufgabe wird außerdem durch ein Verfahren zur Herstellung einer Zwischenschicht zwischen einem CMOS- Chip und einem keramischen Basiselement gelöst, wobei im ersten Schritt Abstandhalter und Teilmengen eines Klebstoffes (A1) auf der Oberfläche des keramischen Basiselementes aufgebracht werden, wobei die aufgebrachten Teilmengen eines Klebstoffes (A1) die Abstandhalter überragen, nachfolgend der CMOS - Chip auf diese abgesetzt und auf den Abstandhaltern und Teilmengen des Klebstoffes (A1) aufliegend verklebt und fixiert wird, und in einem zweiten Schritt der verbliebene Spalt zwischen CMOS - Chip und einem keramischen Basiselement durch einen Klebstoff (B) vollständig ausgefüllt wird, wobei der Klebstoff (B) an einer Seite des waagerecht liegenden CMOS - Chip aufgsgsben wird und der Klebstoff (B) dann durch Kapillarkräfte eingetragen wird und aushärtet.

Außerdem wird die Aufgabe durch ein Verfahren zur Herstellung einer Zwischenschicht zwischen einem Szintillator und einem CMOS- Chip gelöst, wobei im ersten Schritt zumindest Teilmengen eines Klebstoffes (A2) auf die sich in optisch nicht aktiven Bereichen der CMOS - Chip - Oberfläche angeordneten Bumps aufgebracht werden, nachfolgend der Szintillator auf die Bumps abgesetzt wird und auf den Bumps und Teilmengen des Klebstoffes (A2) aufliegend verklebt und fixiert wird, und in einem zweiten Schritt der verbliebene Spalt zwischen Szintillator und dem CMOS - Chip durch einen Klebstoff (B) vollständig ausgsfüllt wird, wobei der Klebstoff (B) an einer Seite des waagerecht liegenden Szintillators aufgegeben und der Klebstoff (B) dann durch Kapillarkräfte eingebracht wird und aushärtet.

Ein weiterer Gegenstand der Erfindung ist ein Röntgenuntersuchungsgerät mit zumindest einem Detektor zum Detektieren von elektromagnetischer Strahlung, mit zumindest einem Szintillator, zumindest einem CMOS- Chip und einem keramischen Basiselement, wobei jeweils zwischen dem Szintillator und dem CMOS - Chip bzw. zwischen dem CMOS - Chip und dem keramischen Basiselement eine und bezüglich ihrer Spaltbreite definierte Zwischenschicht angeordnet ist und diese Zwischenschicht zumindest zwei Klebstoffe (A, B) mit unterschiedlicher Konsistenz und Abstandhalter enthält.

Ausführungsbeispiele der Erfindung werden im folgenden anhand der Zeichnung näher erläutert. Es zeigen:
- Fig. 1: die schematische Seitenansicht eines Teiles eines Detektors 1 mit einer Zwischenschicht 2 zwischen einem CMOS - Chip 3 und einem keramischen Basiselement 4 und
- Fig. 2: die schematische Seitenansicht eines Teiles eines Detektors 1 mit einer Zwischenschicht 2 zwischen einem Szintillator 6 und einem CMOS - Chip 3.

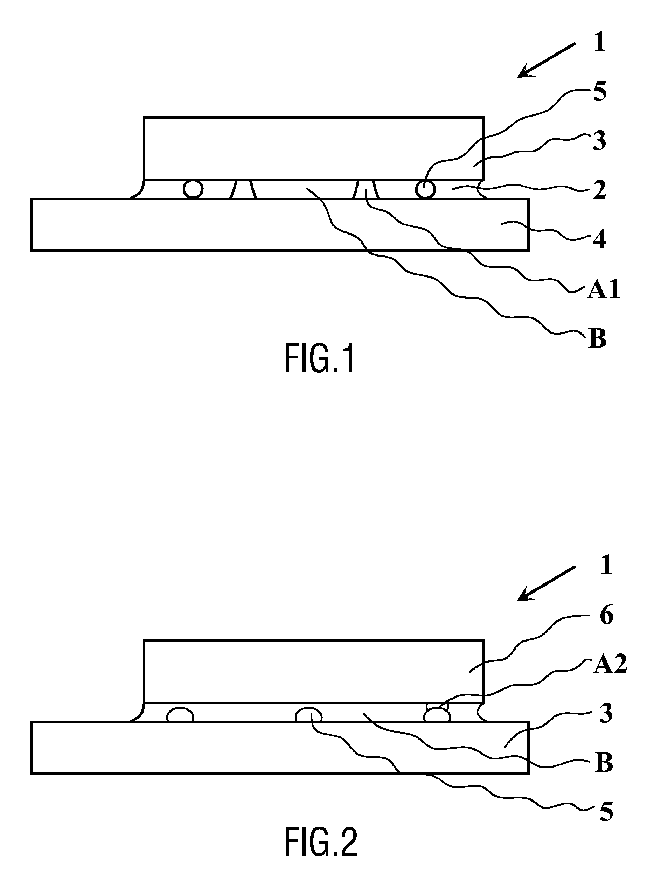

In der Figur 1 ist ein Teil eines Detektors 1 mit einer Zwischenschicht 2 zwischen einem CMOS - Chip 3 und einem keramischen Basiselement 4 nach Abschluss des Verfahrens zur Herstellung einer diesbezüglichen Zwischenschicht dargestellt. Diese Ergebnis wird in der industriellen Fertigung durch die folgenden Verfahrensschritte erreicht:

Auf die Oberfläche des keramischen Basiselemtes 4, welche aus bondbarem Material, beispielsweise AgPt, besteht, werden in herkömmlicher Standardtechnologie Abstandhalter 5, hier Au - Drähte mit einem Durchmesser von 30 µm, gesetzt. Neben diese beiden Drähte die parallel zur Fließrichtung des Klebstoffes (B) angeordnet sind, werden, ohne diese zu berühren, vier Teilmengen des Klebstoffes (A1), hier ein relativ schnell härtender leitfähiger 2-Komponenten Epoxidharz- Klebstoff, mittels handelsüblicher Dispenser aufgebracht. Die Teilmengen des Klebstoffes (A1) sind Tropfen, die ca. 40 µm über die Oberfläche des keramischen Basiselementes 4 hervor ragen. Der CMOS - Chip 3 wird mittels einer halbautomatischen Positioniervorrichtung, die insbesondere übliche Mess- und Positionermittel sowie Datentechnik umfasst, über dem keramischen Basiselement 4 in die gewünschte genau bestimmte Position gebracht und waagerecht abgesetzt.

Nach dem Absetzen, wobei der CMOS - Chip 3 zuerst die Oberfläche der Tropfen des Klebstoffes (A1) berührt, kommt der CMOS - Chip 3 allein unter dem Einfluss der Schwerkraft auf den Abstandhaltern 5 zu liegen. Die Tropfen des Klebstoffes (A1), die nunmehr mit dem keramischen Basiselement 4 als auch dem CMOS - Chip 3 in Kontakt stehen, härten in dieser Lage aus.

Nach dem Aushärten, vorzugsweise unter Wärmeeinwirkung, was am Flip - Chip -Bonder erfolgen kann, ist der gewünschte und genau definierte Spalt mit einer Spaltbreite von ca. 30 µm mechanisch stabil realisiert.

Nachfolgend wird der Klebstoff (B), nur von einer Seite des CMOS - Chip 3, seitlich in den Spalt mittels Dispenser blasenfrei zu geführt, wobei zuvor der gesamte Aufbau, d.h. insbesondere die Komponenten der Zwischenschicht 2 der CMOS-Chip 3 und das keramische Basiselement 4, auf 80 °C erwärmt wird. Der Klebstoff (B), dessen Viskosität auf das erforderliche Fließverhalten abgestimmt ist, füllt unter der Wirkung von Kapillarkräften den Spalt vollständig und blasenfrei aus. An den drei anderen Öffnungen des Spaltes bildet der Klebstoff (B) jeweils einen Meniskus aus, tritt aber selbst nicht aus. Die sich im Spalt befindlichen ausgehärteten Tropfen des Klebstoffes (A1) sowie die Abstandhalter wirken sich auf Grund ihrer geringen Abmessungen nicht signifikant auf das Fließverhalten und die Blasenbildung aus Nach dem Aushärten des Klebstoffes (B) bei geringer Wärmezufuhr, d.h. 60 C über ca. 2,5 Stunden, liegt eine stabile Zwischenschicht 2 vor, die die erforderliche Langzeitstabilität gewährleistet.

In der Figur 2 ist ein Teil eines Detektors 1 mit einer Zwischenschicht 2 zwischen einem CMOS - Chip 3 und einem Szintillator 6 nach Abschluss des Verfahrens zur Herstellung einer diesbezüglichen Zwischenschicht 2 dargestellt. Dieses vorgenannte Ergebnis wird in der industriellen Fertigung durch die folgenden Verfahrensschritte erreicht:

Auf dem CMOS- Chip 3 befinden sich in optisch nicht aktiven Bereichen ca. 30 µm hohe Abstandhalter 5, hier NiAu - Bumps. Diese Bumps sind bezüglich ihrer Höhe mittels üblicher Technologien auf die gewünschte Höhe des Spaltes der Zwischenschicht 2 genau bemessen. Nur auf die Spitzen einzelner Bumps, die regelmäßig eine Fläche von ca. 40 x 40 µm einnehmen, werden Tropfen des Klebstoffes (A2) gesetzt. Der Klebstoff (A) ist ein relativ schnell härtender Klebstoff, der mittels handelsüblicher Dispenser leicht aufgebracht werden kann. Der Szintillator 6 wird mittels einer halbautomatischen Positioniervorrichtung über CMOS - Chip 3 in die gewünschte genau bestimmte Position gebracht und waagerecht abgesetzt. Nach dem Absetzen, wobei der Szintillator 6 zuerst die Oberfläche der Tropfen des Klebstoffes (A2) berührt, kommt der Szintillator 6 allein unter dem Einfluss der Schwerkraft auf den Abstandhaltern 5 waagerecht zu liegen. Die Tropfen des Klebstoffes (A2), die nunmehr mit dem Szintillator 6 als auch den Bumps in Kontakt stehen, härten in dieser Lage aus. Nach dem Aushärten, vorzugsweise unter Wärmeeinwirkung, was am Bonder erfolgen kann, ist der gewünschte und genau definierte Spalt mit einer Spaltbreite von ca. 30 µm mechanisch stabil realisiert. Nachfolgend wird der Klebstoff (B), nur von einer Seite des CMOS - Chip 3, seitlich in den Spalt mittels Dispenser blasenfrei zugeführt. Der Klebstoff (B), dessen Viskosität auf das erforderliche Fließverhalten abgestimmt ist, füllt unter der Wirkung von Kapillarkräften den Spalt vollständig und blasenfrei aus. An den drei anderen Seiten des Spaltes bildet der Klebstoff (B) jeweils einen Meniskus aus, tritt aber selbst nicht aus. Die sich im Spalt befindlichen Abstandhalter 5 wirken sich auf Grund ihrer geringen Abmessungen nicht signifikant auf das Fließverhalten und die Blasenbildung aus. Abstandhalter 5 oder ausgehärtete Teilmengen des Klebstoffes (A2), die eine Grundfläche von größer als 100 x 100 µm einnehmen, sind bei Spalthöhen von kleiner als 50 µm nicht mehr umfließbar ohne dass die Gefahr von unerwünschter Blasenbildung besteht. Nach dem Aushärten des Klebstoffes (B) bei geringer Wärmezufuhr, d.h. 60 C über ca. 2,5 Stunden, liegt eine stabile Zwischenschicht 2 vor, die die erforderliche Langzeitstabilität gewährleistet.

## Patentansprüche

1. Detektor zum Detektieren von elektromagnetischer Strahlung mit zumindest einem Szintillator (6), zumindest einem CMOS - Chip (3) und einem keramischen Basiselement (4), wobei jeweils zwischen dem Szintillator (6) und dem CMOS - Chip (3) bzw. zwischen dem CMOS - Chip (3) und dem keramischen Basiselement (4) eine bezüglich ihrer Spaltbreite definierte Zwischenschicht (2) angeordnet ist und diese Zwischenschicht (2) zumindest zwei Klebstoffe (A, B) mit unterschiedlicher Konsistenz und Abstandhalter (5) enthält.

2. Detektor nach Anspruch 1,
**dadurch gekennzeichnet,**
**dass** die Spaltbreite der Zwischenschicht (2) durch Teilmengen des Klebstoffes (A) und mehreren Abstandhaltern (5) bestimmt wird.

3. Detektor nach Anspruch 1 and 2,
**dadurch gekennzeichnet,**
**dass** der Klebstoff (A) ein schnell härtender Epoxidharz-, Cyanacrylat- oder Acrylatklebstoff ist.

4. Detektor nach Anspruch 3,
**dadurch gekennzeichnet,**
**dass** zumindest einige Teilmengen des Klebstoffes (A1) direkt mit den rückseitigen Oberflächen des CMOS -Chips (3) und dem keramischen Basiselement (4) verbunden sind und zwischen den Oberflächen des CMOS - Chips (3) und dem keramischen Basiselement (4) mehrere Abstandhalter (5) angeordnet sind.

5. Detektor nach Anspruch 4,
**dadurch gekennzeichnet,**
**dass** der Abstandhalter (5) ein Draht ist, der insbesondere aus den Werkstoffen Au und AlSil besteht.

6. Detektor nach Anspruch 3,
**dadurch gekennzeichnet,**
**dass** zumindest einige Teilmengen des Klebstoffes (A2) sowohl mit der dem CMOS-Chip zugewandten Oberfläche des Szintillators (6) als auch mit den auf dem CMOS - Chip (3) befindlichen Bumps verbunden sind.

7. Detektor nach Anspruch 1,
**dadurch gekennzeichnet,**
**dass** der Klebstoff (B) ein niederviskoser Klebstoff, insbesondere auf Epoxidharzbasis ist.

8. Detektor nach Anspruch 1,
**dadurch gekennzeichnet,**
**dass** das keramische Basiselement (4) auf Aluminiumoxid basiert.

9. Verfahren zur Herstellung einer Zwischenschicht zwischen einem CMOS- Chip (3) und einem keramischen Basiselement (4), wobei im ersten Schritt Abstandhalter (5) und Teilmengen eines Klebstoffes (A1) auf einer Oberfläche des keramischen Basiselementes (4) aufgebracht werden, wobei die aufgebrachten Teilmengen eines Klebstoffes (A1) die Abstandhalter (5) überragen, nachfolgend der CMOS - Chip (3) auf diese abgesetzt wird und auf den Abstandhaltern (5) und Teilmengen des Klebstoffes (A1) aufliegend verklebt und fixiert wird, und in einem zweiten Schritt der verbliebene Spalt zwischen CMOS - Chip (3) und dem keramischen Basiselement (4) durch einen Klebstoff (B) vollständig ausgefüllt wird, wobei der Klebstoff (B) an einer Seite des waagerecht liegenden CMOS - Chip (3) aufgegeben wird und der Klebstoff (B) dann durch Kapillarkräfte eingetragen wird und aushärtet.

10. Verfahren zur Herstellung einer Zwischenschicht zwischen einem Szintillator (6) und einem CMOS - Chip (3), wobei im ersten Schritt zumindest Teilmengen des Klebstoffes (A2) auf die sich in optisch nicht aktiven Bereichen der CMOS - Chip-Oberfläche angeordneten Bumps aufgebracht werden, nachfolgend der Szintillator (6) auf die Bumps abgesetzt wird und auf den Bumps und Teilmengen eines Klebstoffes (A2) aufliegend verklebt und fixiert wird, und in einem zweiten Schritt der verbliebene Spalt zwischen Szintillator (6) und dem CMOS - Chip (3) durch einen Klebstoff (B) vollständig ausgefüllt wird, wobei der Klebstoff (B) an einer Seite des waagerecht liegenden Szintillators (6) aufgegeben und der Klebstoff (B) dann durch Kapillarkräfte eingebracht wird und aushärtet.

11. Verfahren zur Herstellung eines Detektors zum Detektieren von elektromagnetischer Strahlung gemäß Anspruch 1, wobei zuerst eine Zwischenschicht (2) zwischen einem CMOS - Chip (3) und einem keramischen Basiselement (4) gemäß Anspruch 9 und nachfolgend eine Zwischenschicht (2) zwischen einem Szintillator (6) und einem CMOS- Chip (3) gemäß Anspruch 10 hergestellt wird.

12. Röntgenuntersuchungsgerät mit zumindest einem Detektor nach einem der Ansprüche 1 bis 8.
